# EUROPEAN PATENT SPECIFICATION

(11) **EP 2 522 156 B1**
(45) Date of publication and mention of the grant of the patent: **06.08.2014**
(21) Application number: 11701418.3
(22) Date of filing: 07.01.2011
(51) Int. Cl.: H04S 1/00, H04R 3/04, H04R 5/04, H03G 7/00, H03G 9/02, H03G 3/34, H04R 3/00, H04R 3/14

(54) **COMPRESSOR BASED DYNAMIC BASS ENHANCEMENT WITH EQ**
KOMPRESSORBASIERTE VERBESSERUNG DES DYNAMISCHEN BASSES MIT EQ
AMPLIFICATION DYNAMIQUE DES BASSES À PARTIR D'UN COMPRESSEUR AVEC ÉGALISATION

(30) Priority: 07.01.2010 US 293005 P
(43) Date of publication of application: 14.11.2012
(73) Proprietor: THAT Corporation, Milford, MA 01757 (US)
(72) Inventor: SKINNER, Scott, Westborough Massachusetts 01581 (US); HANNA, Christopher M., Arlington Massachusetts 02474 (US)
(74) Representative: Guy, Elizabeth
(86) International application number: PCT/US2011/020445
(87) International publication number: WO 2011/085148

(56) References cited:
- WO-A1-2010/057134
- WO-A2-02/074013
- JP-A- 9 232 896
- US-A1- 2008 069 385

## Description

### Cross-Reference to Related Application

This application is based upon and claims priority to U.S. provisional patent application 61/293,005, entitled "Compressor Based Dynamic Bass Enhancement," filed on January 7, 2010 in the names of Scott Skinner and Chris Hanna.

This application is also a continuation-in-part application of U.S. patent application 12/619,653, entitled "Dynamic Volume Control and Multi-Spatial Processing Protection," filed November 16, 2009 in the names of Christopher M. Hanna, Gregory Benulis and Scott Skinner, and U.S. patent application 12/619,655, entitled "Dynamic Volume Control and Multi-Spatial Processing Protection", filed November 16, 2009 in the names of Christopher M. Hanna and Gregory Benulis, (the "Co-pending Applications"), both of the Co-pending Applications claiming priority from U.S. Provisional Application Nos. 61/114,684 filed on 14 November 2008 in the names of Christopher M. Hanna, Gregory Benulis and Scott Skinner; and 61/114,777 filed on 14 November 2008 in the names of Christopher M Hanna and Gregory Benulis.

### Background

### Technical Field

This disclosure relates to audio reception and playback, and more particularly to systems for and techniques of enhancing the perceived bass response of inexpensive speakers typically incorporated into audio and video reception and playback devices such as televisions and computers.

### Description of Related Art

Most consumers are much more sensitive to the quality of visual displays than they are to sound quality. In order to keep cost at a minimum, consumer electronics manufacturers of audio and video systems, such as televisions and computers, thus are more likely to install small, inexpensive speakers in the systems. These speakers typically have poor low frequency (bass) response and become more prone to distortion as the audio frequency moves further below the speaker's low frequency resonance point. For those consumers who are more discerning, the audio and video reception and playback systems are usually configured so that additional speakers can be connected to the audio and video reception and playback systems for improving the quality of the audio portion of any programming.

WO 02/074013 A2 discloses a method of enhancing low frequency components of a digital audio signal having left and right channel signals.

### Summary

The disclosure describes a system for and technique of improving the perceived bass response of such internally mounted speakers of a system that receives and plays back audio programming. The disclosed system and technique also provides enhancement of the amount of bass so that sound appears to be emanating from higher quality, wider bandwidth speakers, without requiring the connection of additional speakers.

More specifically, in accordance with one aspect, a system is provided for enhancing the low frequency response of a loudspeaker for relatively low input level audio signals and protecting the loudspeaker for relatively high input level audio signals. The system comprises: a crossover network configured so as to separate an audio input signal into at least two frequency bands including a low frequency band; and a signal compressor responsive to the energy level of the low frequency portion of an input audio signal in the low frequency band and configured to provide amplification gain on the low frequency portion of the input signal when the energy level of the low frequency portion of the input signal is relatively low so as to enhance the low frequency response of the loudspeaker, and attenuation of the low frequency portion of the input signal when the energy level of the low frequency portion of the input signal is relatively high so as to protect the loudspeaker from being overdriven. The system is configured to enhance the low frequency response of at least two loudspeakers for left and right channel stereo play, and the crossover network is configured to separate each left and right channel audio input signals into at least two frequency bands including a low frequency band. The signal compressor is responsive to the energy level of the low frequency portion of each of the left and right audio input signals in the low frequency band and configured to provide amplification gain on the low frequency portion of each of the left and right channel audio input signals when the energy level of the low frequency portion of each of the signals is relatively low so as to enhance the low frequency response of each of the loudspeakers, and provide attenuation of the low frequency portion of each of the left and right channel audio input signals when the energy level of the low frequency portion of each of the signals is relatively high so as to protect each loudspeaker from being overdriven. The system further comprises a signal summer configured to provide a summed compressed signal representing the sum of the compressed output signals of the signal compressor of left and right channels, and at least two summing blocks for providing left and right channel summed signals as a function of the summed compressed signal and the portion of each left and right channel signal provided in each remaining frequency band.

In accordance with other aspects, the crossover network is configured to separate the audio signal into two frequency bands, wherein parameters of the system are configurable to optimize for a given speaker characteristic or listener preference. The configurable parameters include one or more of the following: crossover frequency, compression ratio, maximum allowable gain, high pass filter cutoff frequency, and target level. In one embodiment, the compressor includes an RMS based level detector for generating a signal representing the energy level of the low frequency portion of the input audio signal. In accordance with another embodiment, a summing block is provided so as to provide a summed signal as a function of the compressed output of the signal compressor signal provided in each remaining frequency band. A high pass filter can be configured to respond to the summed signal and limit the lowest frequency energy applied to the loudspeaker. Further, a peak limiter can be configured to respond to the summed signal and limit the maximum peak level of signal energy applied to loudspeaker. It should be obvious that the peak limiter could also be placed, in the low band, before the summer and respond to the compressor output. The system can further include a static equalizer configured to respond to the summed signal, the static equalizer including a lower limit greater than or equal to the crossover frequency of the cross over network so that the static equalizer, combined with the compressor, operates as a partially dynamic equalizer. Finally, in accordance with another embodiment, the system can include a pair of summing blocks for providing a pair of summed signals as a function of the compressed output signal of the signal compressor of the left channel and the corresponding signals of remaining frequency bands of the left channel, and the compressed output signal of the signal compressor of the right channel and the corresponding signals of the remaining bands of the right channel.

In accordance with another aspect, a method of enhancing the low frequency response of a loudspeaker is provided for relatively low input level audio signals and protecting the loudspeaker for relatively high input level audio signals. The method comprises: separating an audio input signal into at least two frequency bands including a low frequency band; compressing the low frequency portion of an input audio signal in the low frequency band so as to provide amplification gain on the low frequency portion of the input signal when the energy level of the low frequency portion of the input signal is relatively low so as to enhance the low frequency response of the loudspeaker, and provide attenuation of the low frequency portion of the input signal when the energy level of the low frequency portion of the input signal is relatively high so as to protect the loudspeaker from being overdriven; and providing a summed compressed signal representing the sum of the compressed signals of the left and right channels, and providing left and right channel summed signals as a function of the summed compressed signal and the portion of each left and right channel signal provided in each remaining frequency band.

These, as well as other components, steps, features, objects, benefits, and advantages, will now become clear from a review of the following detailed description of illustrative embodiments, the accompanying drawings, and the claims.

### Brief Description of Drawings

The drawings disclose illustrative embodiments. They do not set forth all embodiments. Other embodiments may be used in addition or instead. Details which may be apparent or unnecessary may be omitted to save space or for more effective illustration. Conversely, some embodiments may be practiced without all of the details which are disclosed. When the same numeral appears in different drawings, it refers to the same or like components or steps. In the drawings:
Fig. 1 is a block diagram of one example of a base enhancement system configured so as to improve the perceived bass response, and tonal balance of speakers of the type that are usually mounted internally in systems which include that ability to receive and play audio programming as well as enhance the amount of bass reproduced so that sound appears to be emanating from higher quality, wider bandwidth speakers;
Fig. 2 is a block diagram of the low band compressor shown and described with respect to Figs. 1 and 5;
Fig. 3 is an example of a typical frequency response plot of one of the bass enhanced outputs (Lo or Ro in Fig. 1) for different input levels;
Fig. 4 is an example of the actual measured output of a sample set of small speakers of the type incorporated into audio and video systems; and
Fig. 5 is a block diagram of an embodiment of a bass enhancement system configured to sum the low band signal to mono..

### DETAILED DESCRIPTION OF ILLUSTRATIVE EMBODIMENTS

Illustrative embodiments are now discussed. Other embodiments may be used in addition or instead. Details which may be apparent or unnecessary may be omitted to save space or for a more effective presentation. Conversely, some embodiments may be practiced without all of the details which are disclosed.

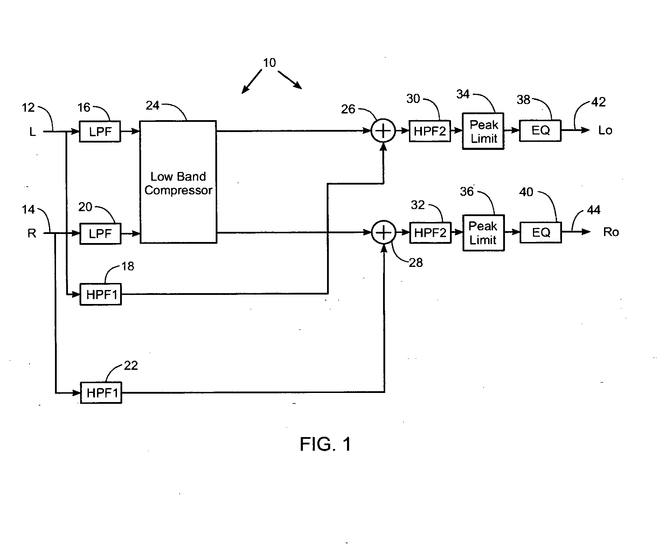

Fig. 1 is a block diagram showing one example of a compressor based bass enhancement system for use in enhancing the bass response of a speaker system. The base enhancement system 10 includes inputs 12 and 14 configured to respectively receive the left and right channel signals of an audio stereo program. Left channel input 12 is coupled to an input of LPF (low pass filter) 16 and an input of HPF1 (high pass filter) 18. Right channel input 14 is coupled to an input of LPF 20 and an input of HPF1 22. The outputs of LPFs 16 and 20 are both connected to a low band compressor 24 configured to compress each signal and provide the compressed signal at a corresponding output of the compressor, wherein the left channel signal is coupled to summing block 26, while the right channel is coupled to summing block 28. Compressing the portion of the audio signal applied to the compressor results in amplifying small signals and attenuating large signals passed through the compressor while applying unity gain for signals somewhere in the middle. The summing blocks 26 and 28 are also coupled to the outputs of HPF1 and HPF2 30 and 32 ,respectively, so that block 26 provides a summed signal as a function of the left channel signal output of the compressor 24 and the left channel signal output of HPF1 18. Similarly, block 28 provides a summed signal as a function of the right channel signal output of the compressor 24 and the right channel signal output of HPF1 22. The left channel summed signal output of the block 26 is then applied to the input of a second HPF2 30, and the right channel summed signal output of block 28 is applied to the input of the second HPF 32. The output of each filter HPF2 30 and HPF2 32 is applied to a respectively peak limiter 34 and 36. The latter limits the peak levels of the respective signals applied to the limiters. The output of limiter 34 is applied to equalizer (EQ) 38 configured to provide at least a two band equalization function on the signal applied to the equalizer. EQ 38 provides the left channel output signal Lo at output 42. Similarly, the output of limiter 36 is applied to EQ 40 configured to provide at least a two band equalization function on the signal applied to the equalizer. EQ 40 provides the left channel output signal Ro at output 44. In accordance with one embodiment, each EQ38 and 40 is a static equalizer configured to respond to the signal applied at its input and establish a lower limit above the crossover frequency of the cross over network formed by filters 16, 18, 20 and 22 so that each static equalizer EQ 38 and 40 operates as a partially dynamic equalizer.

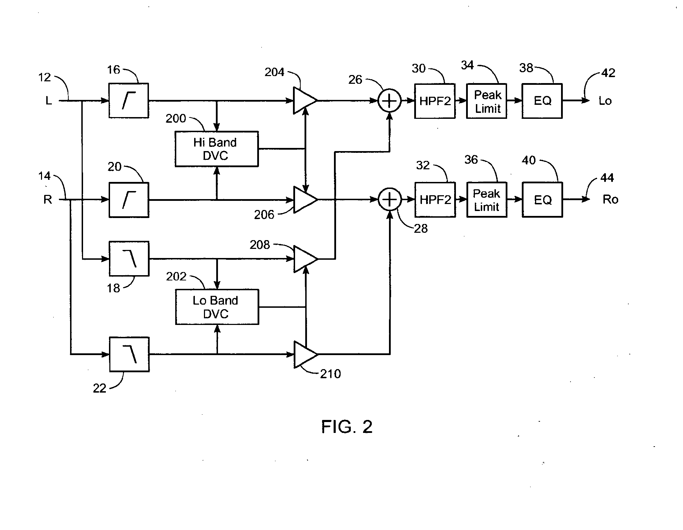

The LPFs 16 and 18, HPF1s 20 and 22 , low band compressor 24 and summing blocks 26, 28 thus combine to form a two-band crossover based architecture. The architecture of the low band compressor 24 can be similar to the dynamic volume control arrangement shown and described in the Co-pending Applications. For example as shown in Fig. 2, the outputs of the left channel HPF 16 and right channel HPF 18 are applied to the Hi Band DVC 200, while the outputs of the left channel LPF 18 and right channel LPF 22 are applied to the inputs of Lo Band DVC 202. The output of Hi Band DVC 200 controls the gain of amplifier 204 which receives the left channel output of HPF 16, and controls the gain of amplifier 206 which receives the right channel output of right channel HPF 20. The outputs of amplifiers 204 and 206 are respectively applied to the summing blocks26 and 28, respectively. Similarly, the output of Lo Band DVC 202 controls the gain of amplifier 208 which receives the left channel output of LPF 18, and the gain of amplifier 210 which receives the right channel output of LPF 22. The outputs of amplifiers 208 and 210 are respectively applied to the summing blocks 26 and 28. It should be noted that by changing the compression ratio of the Hi Band DVC 200 to 1:1 so that the gain applied to amplifiers 204 and 206 is unity gain, the outputs of the left channel HPF 16 and right channel HPF 18 pass through the amplifiers to the respective summing blocks 26 and 28 unchanged. Further, the Lo Band DVC 202 can be adjusted for various parameters including the change target level, compression ratio, attack time constant and release time constant to model the dynamic bass boost function all tailored to the specific speaker systems receiving the Lo and Ro outputs. In one embodiment the Lo Band DVC and Hi Band DVC each include an RMS level detector for use in controlling the gains of the corresponding amplifiers 204, 206 and amplifiers 208 and 210. Further, amplifiers 204, 206, 208 and 210 can each be in the form of voltage control amplifiers. It should be appreciated that other architectures and components can be used. For example, one can use other types of signal compressors as well as other types of level detectors including peak and averaging detectors.

Referring again to Fig. 1, the compressor outputs of compressor 24 are summed with the high band energy provided at the outputs of HPF1 18 and 22 so as to complete the crossover network. HPF2 30 and 32 limit the lowest frequency that reaches each of the loudspeakers. This prevents the lowest frequencies that cannot be reasonably reproduced from reaching the speaker driver. Occasionally, the compressor may briefly provide too much gain (overshoot) to the input low band audio signal. :The Peak limiter is provided to protect the speaker from this phenomenon. The peak limiter is positioned after the crossover network to limit the combined low and high band audio peaks to prevent overdriving the speaker. The Equalizer (EQ) can be used to flatten the speaker frequency response at those frequencies above the low band. The combination of improved tonal balance (EQ) and improved low frequency response (compressor based dynamic boost) can make a dramatic improvement in the fidelity of small speakers.

The compressor target level is set relatively high when compared to typical input signal bass frequency levels. This results in the compressor typically adding gain to the left and right low band audio input signals in order to maintain the desired low band output level. The amount of gain is controlled both by the compressor target level and the compression ratio. The amount of bass enhancement can be increased by increasing the target compressor target level. The amount of bass enhancement can be decreased by decreasing the compressor target level. The amount of bass enhancement is dynamic since the gain (or attenuation) applied to the left and right input audio is a function of the input level. In one implementation the compressor has a maximum gain limit. This limit helps minimize the compressor's affect on the tonal balance of the audio. In addition to bass enhancement, the speakers are also protected from high levels of low-band energy. The compressor will attenuate the input left and right audio when the level exceeds the compressor target level. The compressor target level is typically adjusted to a level just below where the low band audio begins to distort the speaker. It should be clear that the parameters such as crossover frequency, target level, HPF2 cutoff frequency, peak limit, maximum gain limit and EQ configuration can be adjusted, for optimal performance, for a given speaker.

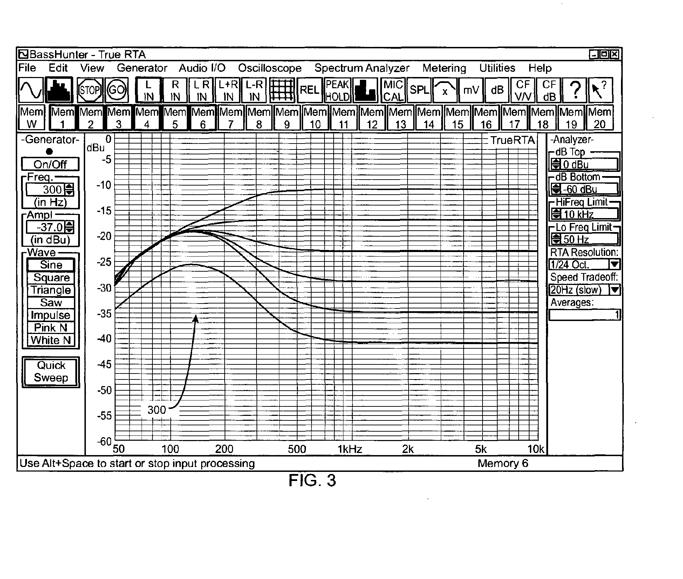

Fig. 3 shows one example of a frequency response plot of one of the bass enhancer outputs (Lo or Ro in Fig. 1) for different input levels. The input level is increased in 6 dB steps. The excitation is a quick sine wave sweep (20-20KHz in less than a second). EQ 38 and 40 were bypassed when this plot was generated.

The high band of the Fig. 3 response remains flat since it is passed unmodified. It exhibits the 6 dB level change of each sweep. The low band is boosted proportional to the input level. Reference is made to the level changes with each sweep around 150 Hz, indicated in Fig. 3 at 300. In the low band the first two lowest input levels exhibit significant boost. The fact that the two lowest level curves are still about 6 dB apart, in the low band, indicates that the compressor 24 has achieved maximum gain. At these input levels the compressor 24 acts like a fixed boost. As the input level continues to increase, less boost is added as the input level approaches the compressor target level. Eventually, the frequency response is flat. As the input level increases, compressor 24 introduces low band attenuation in order to protect the speaker from being driven at levels which would cause high distortion. When the target level is chosen slightly below the maximum low frequency drive level, the compressor based bass enhancement system provides as much boost as possible without driving the speaker into distortion. When this feature is combined with high band EQ (to flatten the speaker high band response) small inexpensive speakers exhibit much improved fidelity.

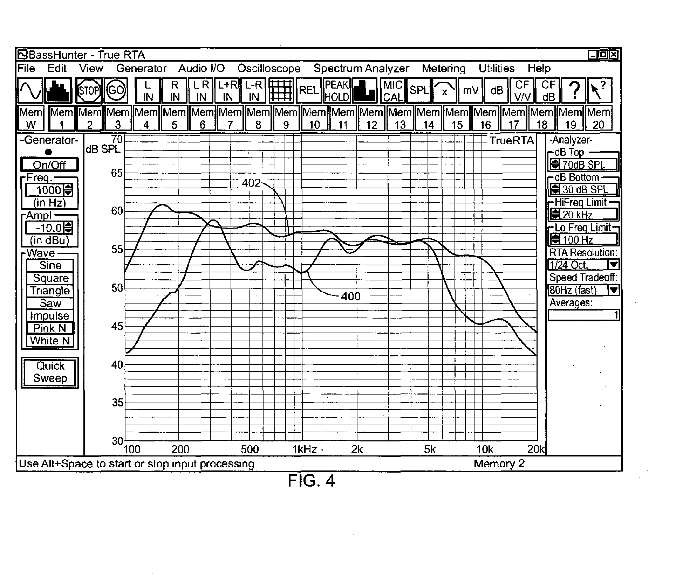

Fig. 4 shows the actual measured output of a sample set of small speakers. The lowest level input response shown at 400 represents the speakers without EQ or low band compressor processing. The speakers have limited bandwidth and do not have a flat response. The next response at 402 represents the same input level after low band bass enhancement and high band EQ. The response is now relatively flat from 150 Hz to 10 KHz.

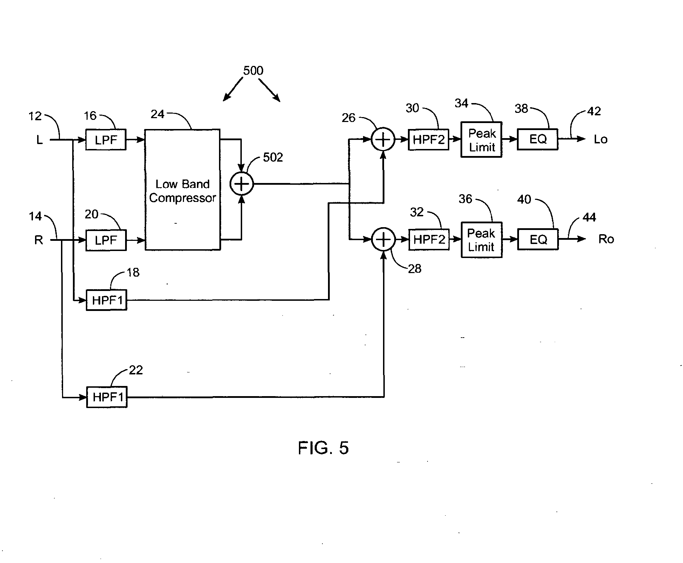

In some instances it is desirable to provide bass enhancement equally to both speakers. Fig. 5 shows a version of the bass enhancement system 500 which includes a summing block 502 configured to sum the low band signals of each channel to provide a monophonic signal, which in turn is applied to each of summing blocks 26 and 28. After the compressor, the L and R signals are attenuated by 6 dB and summed together to create a mono low band signal. This distributes the bass energy equally between the two speakers and can result in more overall perceived bass.

The components, steps, features, objects, benefits and advantages which have been discussed are merely illustrative. None of them, nor the discussions relating to them, are intended to limit the scope of protection in any way. Numerous other embodiments are also contemplated. These include embodiments which have fewer, additional, and/or different components, steps, features, objects, benefits and advantages. These also include embodiments in which the components and/or steps are arranged and/or ordered differently.

For example, while the system has been described as employing two frequency bands, the system can employ any number of bands when additional signal processing of individual bands is desirable

Unless otherwise stated, all measurements, values, ratings, positions, magnitudes, sizes, and other specifications which are set forth in this specification, including in the claims which follow, are approximate, not exact. They are intended to have a reasonable range which is consistent with the functions to which they relate and with what is customary in the art to which they pertain.

The phrase "means for" when used in a claim is intended to and should be interpreted to embrace the corresponding structures and materials which have been described and their equivalents. Similarly, the phrase "step for" when used in a claim is intended to and should be interpreted to embrace the corresponding acts which have been described and their equivalents. The absence of these phrases in a claim mean that the claim is not intended to and should not be interpreted to be limited to any of the corresponding structures, materials, or acts or to their equivalents.

Nothing which has been stated or illustrated is intended or should be interpreted to cause a dedication of any component, step, feature, object, benefit, advantage, or equivalent to the public, regardless of whether it is recited in the claims.

The scope of protection is limited solely by the claims which now follow. That scope is intended and should be interpreted to be as broad as is consistent with the ordinary meaning of the language which is used in the claims when interpreted in light of this specification and the prosecution history which follows and to encompass all structural and functional equivalents.

## Claims

1. A system (10) for enhancing the low frequency response of a loudspeaker for relatively low input level audio signals and protecting the loudspeaker for relatively high input level audio signals, the system comprising:
a crossover network (16, 18, 20, 22) configured so as to separate an audio input signal into at least two frequency bands including a low frequency band; and
a signal compressor (24) responsive to the energy level of the low frequency portion of an input audio signal in the low frequency band and configured to provide amplification gain on the low frequency portion of the input signal when the energy level of the low frequency portion of the input signal is relatively low so as to enhance the low frequency response of the loudspeaker, and provide attenuation of the low frequency portion of the input signal when the energy level of the low frequency portion of the input signal is relatively high so as to protect the loudspeaker from being overdriven;
wherein the system is configured to enhance the low frequency response of at least two loudspeakers for left (12) and right (14) channel stereo play;
the crossover network is configured to separate each of a left and right channel audio input signals into at least two frequency bands including a low frequency band; and
the signal compressor is responsive to the energy level of the low frequency portion of each of the left and right audio input signals in the low frequency band and configured to provide amplification gain on the low frequency portion of each of the left and right channel audio input signals when the energy level of the low frequency portion of each of the signals is relatively low so as to enhance the low frequency response of each of the loudspeakers, and provide attenuation of the low frequency portion of each of the left and right channel audio input signals when the energy level of the low frequency portion of each of the signals is relatively high so as to protect each loudspeaker from being overdriven;
wherein the system further comprises a signal summer (502) configured to provide a summed compressed signal representing the sum of the compressed output signals of the signal compressor of the left and right channels, and at least two summing blocks (26, 28) for providing left (12) and right (14) channel summed signals as a function of the summed compressed signal and the portion of each left and right channel signal provided in each remaining frequency band.

2. A system (10) according to claim 1, wherein the crossover network (16, 18, 20, 22) is configured to separate the audio signal into two frequency bands.

3. A system (10) according to claim 1, wherein parameters of the system are configurable to optimize for a given speaker characteristic or listener preference.

4. A system (10) according to claim 3, wherein the configurable parameters include one or more of the following: crossover frequency, compression ratio, maximum allowable gain, high pass filter cutoff frequency and target level.

5. A system (10) according to claim 1 where the compressor (24) includes an RMS based level detector for generating a signal representing the RMS energy level of the low frequency portion of the input audio signal.

6. A system (10) according to claim 1, further including a summing block (26, 28) for providing a summed signal as a function of the compressed output of the signal compressor and the signal provided in each of any remaining frequency bands.

7. A system (10) according to claim 6, further including a high frequency filter (30, 32) configured to respond to the summed signal and limit the lowest frequency energy applied to the loudspeaker.

8. A system (10) according to claim 6, further including a peak limiter (34, 36) configured to respond to the summed signal and limit the maximum peak level of signal energy applied to loudspeaker.

9. A system (10) according to claim 6, further including a peak limiter configured, before the summing block, to respond to the compressed output of the signal compressor (24) and limit the maximum peak level of signal energy in the low frequency band only.

10. A system (10) according to claim 6, further including a static equalizer (38, 40) configured to respond to the summed signal and including a lower limit greater than or equal to the crossover frequency of the crossover network (16, 18, 20, 22) so that the static equalizer, when combined with the low band compressor (24), operates as a partially dynamic equalizer.

11. A system (10) according to claim 1, further including a pair of summing blocks (26, 28) for providing a pair of summed signals as a function of the compressed output signal of the signal compressor (24) of the left channel (12) and the corresponding signals of remaining frequency bands of the left channel, and the compressed output signal of the signal compressor of the right channel (14) and the corresponding signals of the remaining bands of the right channel.

12. A method of enhancing the low frequency response of at least two loudspeakers for relatively low input level audio signals and protecting the loudspeakers for relatively high input level audio signals, the method comprising:
separating each of a right and a left audio input signal into at least two frequency bands including a low frequency band;
compressing the low frequency portion of each of the right and the left input audio signals in the low frequency band so as to provide amplification gain on the low frequency portion of each of the right and the left input signals when the energy level of the low frequency portion of each of the right and the left input signals is relatively low so as to enhance the low frequency response of each of the loudspeakers, and provide attenuation of the low frequency portion of each of the right and the left input signals when the energy level of the low frequency portion of each of the right and the left input signals is relatively high so as to protect each of the loudspeakers from being overdriven; and
providing a summed compressed signal representing the sum of the compressed low frequency portions of the left and right signals (12, 14), and providing left and right channel summed signals as a function of the summed compressed signal and the portion of each left and right input signal provided in each remaining frequency band.

13. A method according to claim 12, further including providing a pair of summed signals as a function of the compressed output signal of the signal compressor (24) of the left input signal (12) and the corresponding signals of remaining frequency bands of the left input signal, and the compressed output signal of the signal compressor of the right input signal (14) and the corresponding signals of the remaining bands of the right input signal.

## Patentansprüche

1. System (10) zum Verbessern des Frequenzgangs im Bassbereich eines Lautsprechers für Audiosignale mit relativ niedrigem Eingangspegel und zum Schützen des Lautsprechers vor Audiosignalen mit relativ hohem Eingangspegel, wobei das System Folgendes umfasst:
eine Frequenzweiche (16, 18, 20, 22), die so konfiguriert ist, dass sie ein Audioeingangssignal in wenigstens zwei Frequenzbänder einschließlich einem Niederfrequenzband aufteilt; und
einen Signalkompressor (24), der auf den Energiepegel des Niederfrequenzteils eines Eingangsaudiosignals im Niederfrequenzband anspricht und zum Bereitstellen von Verstärkungsgewinn im Niederfrequenzteil des Eingangssignals konfiguriert ist, wenn der Energiepegel des Niederfrequenzteils des Eingangssignals relativ niedrig ist, um den Frequenzgang im Bassbereich des Lautsprechers zu verbessern, und zum Bereitstellen von Dämpfung des Niederfrequenzteils des Eingangssignals, wenn der Energiepegel des Niederfrequenzteils des Eingangssignals relativ hoch ist, um den Lautsprecher vor Übersteuerung zu schützen;
wobei das System zum Verbessern des Frequenzgangs im Bassbereich von wenigstens zwei Lautsprechern für links- (12) und rechtskanalige (14) Stereowiedergabe konfiguriert ist;
wobei die Frequenzweiche zum Aufteilen jedes der links- und rechtskanaligen Audioeingangssignale in wenigstens zwei Frequenzbänder einschließlich einem Niederfrequenzband konfiguriert ist; und
der Signalkompressor auf den Energiepegel des Niederfrequenzteils von jedem der linken und rechten Audioeingangssignale im Niederfrequenzband anspricht und zum Bereitstellen von Verstärkungsgewinn im Niederfrequenzteil von jedem der links- und rechtskanaligen Audioeingangssignale konfiguriert ist, wenn der Energiepegel des Niederfrequenzteils von jedem der Signale relativ niedrig ist, um den Frequenzgang im Bassbereich von jedem der Lautsprecher zu verbessern und Dämpfung des Niederfrequenzteils von jedem der links- und rechtskanaligen Audioeingangssignale bereitzustellen, wenn der Energiepegel des Niederfrequenzteils von jedem der Signale relativ hoch ist, um jeden Lautsprecher vor Übersteuerung zu schützen;
wobei das System ferner ein Signalsummierglied (502), das zum Bereitstellen eines summierten komprimierten Signals konfiguriert ist, das die Summe der komprimierten Ausgangssignale des Signalkompressors des linken und rechten Kanals repräsentiert, und wenigstens zwei Summierblöcke (26, 28) zum Bereitstellen von summierten links- (12) und rechtskanaligen (14) Signalen in Abhängigkeit von dem summierten komprimierten Signal und dem Teil jedes in jedem verbleibenden Frequenzband bereitgestellten rechts- und linkskanaligen Signals umfasst.

2. System (10) nach Anspruch 1, wobei die Frequenzweiche (16, 18, 20, 22) zum Aufteilen des Audiosignals in zwei Frequenzbänder konfiguriert ist.

3. System (10) nach Anspruch 1, wobei Parameter des Systems zum Optimieren für eine gegebene Lautsprechercharakteristik oder Zuhörerpräferenz konfigurierbar sind.

4. System (10) nach Anspruch 3, wobei die konfigurierbaren Parameter eines oder mehrere der Folgenden beinhalten: Übergangsfrequenz, Kompressionsverhältnis, maximal zulässiger Gewinn, Hochpassfilter-Grenzfrequenz und Zielpegel.

5. System (10) nach Anspruch 1, wobei der Kompressor (24) einen Pegeldetektor auf RMS-Basis zum Erzeugen eines Signals beinhaltet, das den RMS-Energiepegel des Niederfrequenzteils des Eingangsaudiosignals repräsentiert.

6. System (10) nach Anspruch 1, das ferner einen Summierblock (26, 28) zum Bereitstellen eines summierten Signals in Abhängigkeit vom komprimierten Ausgang des Signalkompressors und von dem in jedem von beliebigen restlichen Frequenzbändern bereitgestellten Signal beinhaltet.

7. System (10) nach Anspruch 6, das ferner ein Hochfrequenzfilter (30, 32) beinhaltet, das zum Ansprechen auf das summierte Signal und zum Begrenzen der niedrigsten auf den Lautsprecher angewandten Frequenzenergie konfiguriert ist.

8. System (10) nach Anspruch 6, das ferner einen Spitzenbegrenzer (34, 36) zum Ansprechen auf das summierte Signal und zum Begrenzen des maximalen Spitzenpegels der auf den Lautsprecher angewandten Signalenergie beinhaltet.

9. System (10) nach Anspruch 6, das ferner einen Spitzenbegrenzer beinhaltet, der so konfiguriert ist, dass er vor dem Summierblock auf den komprimierten Ausgang des Signalkompressors (24) anspricht und den maximalen Spitzenpegel von Signalenergie nur im Niederfrequenzband begrenzt.

10. System (10) nach Anspruch 6, das ferner einen statischen Equaliser (38, 40) beinhaltet, der zum Ansprechen auf das Signal konfiguriert ist und eine Untergrenze aufweist, die gleich oder größer als die Übergangsfrequenz der Frequenzweiche (16, 18, 20, 22) ist, so dass der statische Equaliser in Kombination mit dem Tiefbandkompressor (24) als teildynamischer Equaliser arbeitet.

11. System (10) nach Anspruch 1, das ferner ein Paar Summierblöcke (26, 28) zum Bereitstellen eines Paares von summierten Signalen in Abhängigkeit vom komprimierten Ausgangssignal des Signalkompressors (24) des linken Kanals (12) und der entsprechenden Signale von restlichen Frequenzbändern des linken Kanals und vom komprimierten Ausgangssignal des Signalkompressors des rechten Kanals (14) und der entsprechenden Signale der restlichen Bänder des rechten Kanals aufweist.

12. Verfahren zum Verbessern des Frequenzgangs im Bassbereich von wenigstens zwei Lautsprechern für Audiosignale mit relativ niedrigem Eingangspegel und zum Schützen der Lautsprecher vor Audiosignalen mit relativ hohem Eingangspegel, wobei das Verfahren Folgendes beinhaltet:
Aufteilen jedes aus einem rechten und einem linken Audioeingangssignal in wenigstens zwei Frequenzbänder einschließlich einem Niederfrequenzband;
Komprimieren des Niederfrequenzteils von jedem der rechten und linken Eingangsaudiosignale im Niederfrequenzband, um Verstärkungsgewinn im Niederfrequenzteil von jedem der rechten und linken Eingangssignale bereitzustellen, wenn der Energiepegel des Niederfrequenzteils von jedem der rechten und linken Eingangssignale relativ niedrig ist, um den Frequenzgang im Bassbereich von jedem der Lautsprecher zu verbessern und Dämpfung des Niederfrequenzteils von jedem der rechten und linken Eingangssignale bereitzustellen, wenn der Energiepegel des Niederfrequenzteils von jedem der Eingangssignale relativ hoch ist, um jeden der Lautsprecher vor Übersteuerung zu schützen; und
Bereitstellen eines summierten komprimierten Signals, das die Summe der komprimierten Niederfrequenzteile der linken und rechten Signale (12, 14) repräsentiert, und Bereitstellen von links- und rechtskanaligen summierten Signalen in Abhängigkeit von dem summierten komprimierten Signal und dem in jedem restlichen Frequenzband bereitgestellten Teil jedes linken und rechten Eingangssignals.

13. Verfahren nach Anspruch 12, das ferner das Bereitstellen eines Paares von summierten Signalen in Abhängigkeit von dem komprimierten Ausgangssignal des Signalkompressors (24) des linken Eingangssignals (12) und der entsprechenden Signale von restlichen Frequenzbändern des linken Eingangssignals und von dem komprimierten Ausgangssignal des Signalkompressors des rechten Eingangssignals (14) und der entsprechenden Signale der restlichen Bänder des rechten Eingangssignals beinhaltet.

## Revendications

1. Système (10) pour améliorer la réponse en basse fréquence d'un haut-parleur pour des signaux audio de niveau d'entrée relativement bas et protéger le haut-parleur pour des signaux audio de niveau d'entrée relativement haut, le système comprenant :
un filtre de voies (16, 18, 20, 22) configuré de manière à séparer un signal d'entrée audio en au moins deux bandes de fréquences comprenant une bande de basse fréquence ; et
un compresseur de signal (24) sensible au niveau d'énergie de la portion de basse fréquence d'un signal d'entrée audio dans la bande de basse fréquence et configuré pour fournir un gain d'amplification sur la portion de basse fréquence du signal d'entrée quand le niveau d'énergie de la portion de basse fréquence du signal d'entrée est relativement bas de manière à améliorer la réponse en basse fréquence du haut-parleur et fournir une atténuation de la portion de basse fréquence du signal d'entrée quand le niveau d'énergie de la portion de basse fréquence du signal d'entrée est relativement haut de manière à protéger le haut-parleur contre une saturation ;
dans lequel le système est configuré pour améliorer la réponse en basse fréquence d'au moins deux haut-parleurs pour la reproduction stéréo des voies gauche (12) et droite (14) ;
le filtre de voies est configuré pour séparer chacun des signaux d'entrée audio gauche et droite en au moins deux bandes de fréquences comprenant une bande de basse fréquence ; et
le compresseur de signal est sensible au niveau d'énergie de la portion de basse fréquence de chacun des signaux d'entrée audio gauche et droit dans la bande de basse fréquence et configuré pour fournir un gain d'amplification sur la portion de basse fréquence de chacun des signaux d'entrée audio des voies gauche et droite quand le niveau d'énergie de la portion de basse fréquence de chacun des signaux est relativement bas de manière à améliorer la réponse en basse fréquence de chacun des haut-parleurs et fournir une atténuation de la portion de basse fréquence de chacun des signaux d'entrée audio des voies gauche et droite quand le niveau d'énergie de la portion de basse fréquence de chacun des signaux est relativement haut de manière à protéger chaque haut-parleur contre une saturation ;
dans lequel le système comprend en outre un sommateur de signaux (502) configuré pour fournir un signal compressé sommé représentant la somme des signaux compressés de sortie du compresseur de signal des voies gauche et droite, et au moins deux blocs de sommation (26, 28) pour fournir des signaux sommés de voies gauche (12) et droite (14) en tant que fonction du signal compressé sommé et de la portion de chaque signal de voie gauche et droite fourni dans chaque bande de fréquences restante.

2. Système (10) selon la revendication 1, dans lequel le filtre de voies (16, 18, 20, 22) est configuré pour séparer le signal audio en deux bandes de fréquences.

3. Système (10) selon la revendication 1, dans lequel des paramètres du système sont configurables pour optimiser une caractéristique d'orateur ou une préférence d'auditeur donnée.

4. Système (10) selon la revendication 3, dans lequel les paramètres configurables comprennent un ou plusieurs des suivants : fréquence de transition, rapport de compression, gain maximal admissible, fréquence de coupure de filtre passe-haut et niveau cible.

5. Système (10) selon la revendication 1, où le compresseur (24) comprend un détecteur de niveau de type efficace pour engendrer un signal représentant le niveau d'énergie efficace de la portion de basse fréquence du signal d'entrée audio.

6. Système (10) selon la revendication 1, comprenant en outre un bloc de sommation (26, 28) pour fournir un signal sommé en tant que fonction de la sortie compressée du compresseur de signal et du signal fourni dans chacune de n'importe quelles bandes de fréquence restantes.

7. Système (10) selon la revendication 6, comprenant en outre un filtre haute fréquence (30, 32) configuré pour répondre au signal sommé et limiter l'énergie de fréquence la plus basse appliquée au haut-parleur.

8. Système (10) selon la revendication 6, comprenant en outre un limiteur de crête (34, 36) configuré pour répondre au signal sommé et limiter le niveau de crête maximal de l'énergie de signal appliquée au haut-parleur.

9. Système (10) selon la revendication 6, comprenant en outre un limiteur de crête configuré, avant le bloc de sommation, pour répondre à la sortie compressée du compresseur de signal (24) et limiter le niveau de crête maximum de l'énergie de signal seulement dans la bande de basse fréquence.

10. Système (10) selon la revendication 6, comprenant en outre un égaliseur statique (38, 40) configuré pour répondre au signal sommé et comprenant une limite inférieure supérieure ou égale à la fréquence de transition du filtre de voies (16, 18, 20, 22) de manière que l'égaliseur statique, quand il est combiné au compresseur de bande basse (24), fonctionne comme un égaliseur partiellement dynamique.

11. Système (10) selon la revendication 1, comprenant en outre une paire de blocs de sommation (26, 28) pour fournir une paire de signaux sommés en tant que fonction du signal de sortie compressé du compresseur de signal (24) de la voie gauche (12) et des signaux correspondants de bandes de fréquences restantes de la voie gauche, et du signal de sortie compressé du compresseur de signal de la voie droite (14) et des signaux correspondants des bandes restantes de la voie droite.

12. Procédé pour améliorer la réponse en basse fréquence d'au moins deux haut-parleurs pour des signaux audio de niveau d'entrée relativement bas et protéger les haut-parleurs pour des signaux audio de niveau d'entrée relativement haut, le procédé comprenant :
la séparation de chacun des signaux d'entrée audio droit et gauche en au moins deux bandes de fréquences comprenant une bande de basse fréquence ;
la compression de la portion de basse fréquence de chacun des signaux d'entrée audio droit et gauche dans la bande de basse fréquence de manière à fournir un gain d'amplification sur la portion de basse fréquence de chacun des signaux d'entrée droit et gauche quand le niveau d'énergie de la portion de basse fréquence de chacun des signaux d'entrée droit et gauche est relativement bas de manière à améliorer la réponse en basse fréquence de chacun des haut-parleurs, et pour fournir une atténuation de la portion de basse fréquence de chacun des signaux d'entrée droit et gauche quand le niveau d'énergie de la portion de basse fréquence de chacun des signaux d'entrée droit et gauche est relativement haut de manière à protéger chacun des haut-parleurs contre une saturation ; et
la fourniture d'un signal compressé sommé représentant la somme des portions de basse fréquence compressées des signaux gauche et droit (12, 14), et la fourniture de signaux sommés de voies gauche et droite en tant que fonction du signal compressé sommé et de la portion de chaque signal d'entrée gauche et droit fourni dans chaque bande de fréquences restante.

13. Procédé selon la revendication 12, comprenant en outre la fourniture d'une paire de signaux sommés en tant que fonction du signal de sortie compressé du compresseur de signal (24) du signal d'entrée gauche (12) et des signaux correspondants de bandes de fréquences restantes du signal d'entrée gauche, et du signal de sortie compressé du compresseur de signal du signal d'entrée droit (14) et des signaux correspondants des bandes restantes du signal d'entrée droit.
